# EUROPÄISCHE PATENTANMELDUNG

(11) **EP 1 020 910 A2**
(43) Veröffentlichungstag der Anmeldung: **19.07.2000**
(21) Anmeldenummer: 00100337.5
(22) Anmeldetag: 07.01.2000
(51) Int. Cl.: H01L 23/40

(54) **Kühlkörperbefestigung**

(30) Priorität: 16.01.1999 DE 19901593
(71) Anmelder: Elsa AG, 52070 Aachen (DE)
(72) Erfinder: Wieninger, Peter, 52072 Aachen (DE)
(74) Vertreter: Kohlmann, Kai, Dipl.-Ing.

(57) **Zusammenfassung**

Die Erfindung betrifft eine Anordnung mit einem auf einer Platine angeordneten elektronischen Bauteil, einem Kühlkörper sowie Befestigungsmitteln, wobei der Kühlkörper auf einer Oberfläche des elektronischen Bauteils aufliegt und die Befestigungsmittel den Kühlkörper elastisch mit der Platine verbinden.

Damit die Anordnung schnell herstellbar und mechanisch dauerhaft ist sowie eine definierte Pressung zwischen Kühlkörper und Bauteil besteht, jedoch gleichzeitig die Befestigungsmittel die Leiterbahnführung auf der Platine weniger oder überhaupt nicht einschränken, wird erfindungsgemäß vorgeschlagen, daß die Befestigungsmittel mindestens zwei Sockel umfassen, die mit der Platine durch Lot verbunden sind.

## Beschreibung

Die Erfindung betrifft eine Anordnung mit einem auf einer Platine angeordneten elektronischen Bauteil, einem Kühlkörper sowie Befestigungsmitteln, wobei der Kühlkörper auf einer Oberfläche des elektronischen Bauteils aufliegt und die Befestigungsmittel den Kühlkörper elastisch mit der Platine verbinden.

Viele elektronische Bauteile entwickeln Verlustleistungen, die ein wirkungsvolles Abführen der erzeugten Wärme erfordern. Kühlkörper dienen der Wärmeabfuhr von elektronischen Bauteilen. Der Wärmewiderstand zwischen Bauteil und Kühlkörper hängt von der Größe, der Bauform und der Einbaulage des Kühlkörpers ab. Um den Wärmewiderstand zwischen Kühlkörper und zu kühlendem Bauteil klein zu halten, ist schließlich eine Verbindung zwischen dem elektronischen Bauteil und dem Kühlkörper erforderlich, die nach folgenden Methoden herstellbar ist:
a) Aufkleben des Kühlkörpers auf das Bauteil und/oder
b) Verbinden des Kühlkörpers mit dem Bauteil mit Hilfe mechanischer Befestigungsmittel, wie beispielsweise Schrauben, Klemmen oder Federn.

Klebeverbindungen können sich aus verschiedenen Gründen lösen, was Störungen oder sogar den Ausfall der das gekühlte Bauelement enthaltenden Baugruppe zur Folge haben kann.

Mechanische Befestigungsmittel zwischen Kühlkörper und elektronischem Bauteil weisen regelmäßig den Nachteil auf, daß bei Verwindung des Systems aus Bauteil, Platine und Kühlkörper, beispielsweise aufgrund thermischer Spannungen, keine definierte Pressung zwischen Kühlkörper und Bauelement erreicht wird. Folglich ändert sich der Wärmewiderstand zwischen Bauteil und Kühlkörper und damit die Kühlleistung.

Um eine definierte Pressung zwischen Kühlkörper und Bauelement zu erreichen wurden bereits mechanische Befestigungsmittel entwickelt, bei denen der mechanische Kraftschluß durch Federn unterstützt wird, die für eine definierte Pressung zwischen Kühlkörper und Bauteil sorgen. Eine Anordnung mit einem durch Federn unterstützten Befestigungsmittel ist in der US-Patent 5,730,210 beschrieben. Aus der US 5,730,210 geht ein Kühlkörper hervor, der auf der ebenen Oberfläche eines auf einer Platine angeordneten Chips aufliegt, um dessen Wärme abzuführen. Der Kühlkörper weist mindestens zwei sich über die Oberfläche des Chips in der Oberflächenebene erstreckende Befestigungsenden auf, die jeweils eine Befestigungsöffnung zur Aufnahme eines Befestigungsbolzens aufweisen. Der Befestigungsbolzen umfaßt einen gegenüber seinem Schaft verdickten Kopf sowie ein Einrastende an der gegenüberliegenden Seite, das in eine dem jeweiligen Bolzen zugeordnete Öffnung der Platine einrastet. Den Schaft des Bolzens umgibt eine Spiralfeder, die einerseits an dem verdickten Kopf und andererseits an dem Befestigungsende anliegt. Infolgedessen übt die Spiralfeder eine Andruckkraft auf die Befestigungsenden aus, so daß der Kühlkörper federnd an den Chip gedrückt wird.

Eine derartige Befestigung ist schnell herstellbar, mechanisch dauerhaft und erzeugt eine definierte Pressung zwischen Kühlkörper und Bauelement. Ein zentraler Nachteil der Befestigung besteht allerdings darin, daß sie relativ große Öffnungen in der Platine erfordert, die mit den Befestigungsbolzen zusammenwirken. Die Stellen, an denen sich die Öffnungen befinden, stehen nicht mehr für die Leiterbahnführung zur Verfügung. Dies ist insbesondere deshalb problematisch, da sich die Öffnungen unmittelbar neben dem zu kühlenden elektronischen Bauteil befinden. Da moderne Bauteile häufig bis zu 1000 Anschlüsse besitzen, ist die Leiterbahnführung erheblich erschwert. Die Leiterbahnen müssen um die Öffnungen in der Platine herumgeführt werden, was zwangsläufig an anderen Stellen eine höhere Leiterbahndichte bedingt und zu erhöhtem elektrischen Übersprechen und allgemein größerer Empfindlichkeit der Schaltung auf der Platine führt.

Selbst in flächigen Leiterbahnlagen, z.B. für die Erdung (GND=Ground) oder die Hauptstromversorgung (VCC=Voltage Common Collector) können die Öffnungen zu hochfrequenzaktiven Effekten, z.B. unerwünschte Wirbeiströmen, führen. Die Befestigungsöffnungen sind insbesondere bei hochkomplexen elektronischen Bauelementen ein ernstzunehmendes Problem, das trotz der Vorteile eine Kühlkörperbefestigung nach der US 5,730,210 an der Platine in Frage stellt.

Ausgehend von diesem Stand der Technik liegt der Erfindung die Aufgabe zugrunde, eine Anordnung der eingangs erwähnten Art zu schaffen, die schnell herstellbar und mechanisch dauerhaft ist sowie eine definierte Pressung zwischen Kühlkörper und Bauteil erzeugt, jedoch gleichzeitig die Nachteile der Anordnung nach der US 5,730,210 vermeidet.

Diese Aufgabe wird bei einer Anordnung der eingangs erwähnten Art erfindungsgemäß dadurch gelöst, daß die Befestigungsmittel mindestens zwei Sockel umfassen, die mit der Platine durch Lot verbunden sind.

Die ohnehin zur Befestigung der Bauteile auf der Platine erforderliche Verlötung ist eine kostengünstige, langzeitstabile und zudem platzsparende Verbindung zwischen Sockel und Platine. Die Sockel lassen sich, wie die übrigen elektronischen Bauteile, mit modernen Bestückungsautomaten im Umfeld des zu kühlenden Bauteils bestücken. Für heutige hochintegrierten Schaltkreise hat sich eine Anzahl von zwei bis vier Sockeln als zweckmäßig herausgestellt.

Wenn der Sockel für SMD-Montage (SMD = Surface Mounted Device) vorgesehen ist und das Lot lediglich auf der Bestückungsseite der Platine aufgebracht wird, sind lediglich bei Platinen mit zweiseitigem Leiterbild auf der Bestückungsseite der Platine die Leiterbahnen um den Sockel herumzuführen. Alle Leiterbahnen auf der Rückseite können ohne Einschränkungen geführt werden.

Aber auch wenn jeder Sockel mindestens einen Draht aufweist, in der Platine Löcher vorgesehen sind, durch die die Drähte der Sockel gesteckt werden und das Lot auf der Rückseite der Platine aufgebracht ist, ergeben sich wesentlich kleinere Bohrungen als bei der aus dem Stand der Technik nach der US 5,730,210 bekannten Anordnung. Die für die Drähte erforderlichen Löcher weisen einen geringen Durchmesser von ca. 0.8mm auf, der die Leiterbahnführung kaum behindert. Schließlich sind regelmäßig mehrere Bohrungen mit geringem Durchmesser auf der Platine durchzuführen. Es ist daher kein Werkzeugwechsel bei der Platinenfertigung notwendig. Dies reduziert die Fertigungskosten.

Unterschiedliche Ausgestaltungen der den Kühlkörper elastisch mit der Platine verbindenden Befestigungsmittel ergeben sich aus den Merkmalen der Ansprüche 4 bis 7. Während die Ausgestaltungen nach den Ansprüchen 4 und 5 auf Spiralfedern zur Erzeugung der Elastizität der Verbindung zurückgreifen, wird in den Ansprüchen 6 und 7 der Einsatz von elastischem Schrumpfmaterial für den Befestigungsbolzen vorgeschlagen. Der Schrumpfungsprozeß des Bolzen erzeugt die notwendige mechanische Spannung zwischen Kühlkörper und Platine, so daß die Spiralfedern entfallen können. Der Schrumpfungsprozeß kann in der Fertigung beispielsweise thermisch eingeleitet werden. Unabhängig davon, ob nun Schrumpfmaterial oder Spiralfedern zum Einsatz kommen, können die Befestigungsbolzen entweder unmittelbar an dem Kühlkörper angreifen oder an einem auf dem Kühlkörper auf liegenden Halteelement, das die Kräfte in den Kühlkörper einleitet. Die Verwendung eines Halteelements erspart konstruktive Anpassungen des Kühlkörpers an die Befestigungsmittel. Das Halteelement wird von Federn, Klemmen oder Bügeln gebildet, die so ausgestaltet sind, daß eine Kraft auf den Kühlkörper in Richtung des zu kühlenden Bauteils entsteht.

Die Verbindung zwischen dem Befestigungsbolzen und dem Sockel kann in Ausgestaltung des Anspruch 8 lösbar sein, um den Bolzen durch die in dem Kühlkörper oder dem Halteelement vorgesehenen Öffnungen hindurchstecken zu können. Hierzu kommen vorzugsweise manuell lösbare Verbindungen, wie Rastverbindungen oder Renkverbindungen, insbesondere Bajonettverbindungen in Betracht.

Alternativ kann die Verbindung zwischen dem Befestigungsbolzen und dem Sockel in Ausgestaltung des Anspruch 9 durch einstückige Ausbildung untrennbar, d.h. nicht zerstörungsfrei lösbar, sein. Dann ist es allerdings erforderlich, daß der Kopf des Bolzens von einem lösbar mit dem Schaft verbundenen und diesen umgebenden Ring gebildet wird, um den Bolzen durch die in dem Kühlkörper oder dem Halteelement vorgesehenen Öffnungen hindurchstecken zu können. Durch diese Maßnahme können wesentliche Teile der Befestigungsmittel bereits mit der Lötung aufgebracht werden.

Eine weitere, sehr einfache und daher preiswerte Ausgestaltung der den Kühlkörper elastisch mit der Platine verbindenden Befestigungsmittel ergibt sich aus den Merkmalen der Ansprüche 10 und 11. Auf den Sockeln sind Haken angeordnet, um die elastischen Zugmittel über den Kühlkörper zu spannen, so daß ein ausreichender Wärmekontakt entsteht. Als Zugmittel kommen insbesondere flexible Bänder, Stahl- oder Kunststoff-Spannfedern in Betracht.

Nachfolgend wird die Erfindung anhand mehrerer Ausführungsbeispiele des näheren erläutert. Es zeigen
- Figur 1: ein erstes Ausführungsbeispiel einer erfindungsgemäßen Anordnung,
- Figur 2: eine Teilansicht eines zweiten Ausführungsbeispiels der Erfindung,
- Figur 3: ein drittes Ausführungsbeispiel der Erfindung mit einem Halteelement,
- Figur 4: ein viertes Ausführungsbeispiel der Erfindung mit einem elastischen Zugmittel,
- Figur 5: eine Teilansicht eines fünften Ausführungsbeispiels der Erfindung mit einem Befestigungsbolzen aus elastischem Schrumpfmaterial,
- Figur 6: ein sechstes Ausführungsbeispiel der Erfindung mit einem einstückig mit einem Sockel ausgebildeten Befestigungsbolzen.

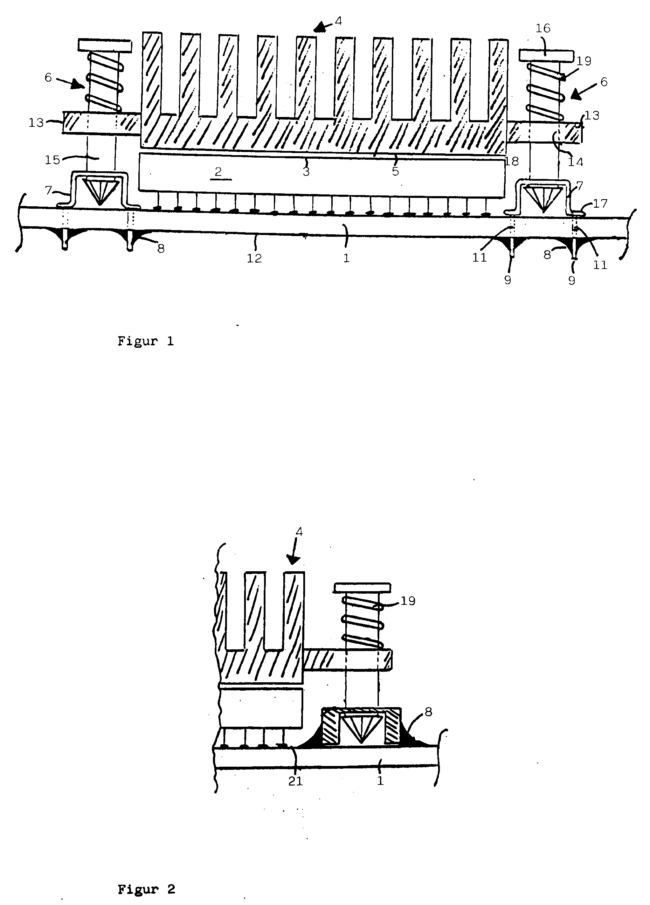

Auf einer teilweise in Figur 1 dargestellten Platine 1 ist ein Chip 2 angeordnet, auf dessen ebener Oberfläche 3 ein insgesamt mit 4 bezeichneter Kühlkörper aufliegt. Zwischen der Oberfläche 3 und der Unterseite 5 des Kühlkörpers 5 wird regelmäßig eine Wärmeleitpaste eingebracht, um den Wärmewiderstand zwischen dem Chip 2 und dem Kühlkörper 4 zu reduzieren. Erfindungsgemäß umfassen die insgesamt mit 6 bezeichneten Befestigungsmittel mindestens zwei Sockel 7, die mit der Platine 1 durch Lot 8 verbunden sind.

Im Ausführungsbeispiel nach Figur 1 weist jeder Sockel 7 zwei Drahtstifte 9 auf, die durch Löcher 11 in der Platine 1 geführt sind. Das Lot 8 zur Befestigung des Sockels 7 an der Platine 1 ist auf der Rückseite 12 der Platine 1 aufgebracht. Der Kühlkörper 4 weist ferner zwei Befestigungsöffnungen 14 aufnehmende Laschen 13 auf, die sich über die Oberfläche 3 des Chips 2 hinaus erstrecken. Im gezeigten Ausführungsbeispiel entsprechen sich die Flächen der Unterseite 5 des Kühlkörpers 4 und der Oberfläche 3 des Chips 2. Dies ist jedoch nicht zwingend. Vielmehr ist es möglich, daß sich die Unterseite 5 des Kühlkörpers 4 über den Chip 2 hinaus erstreckt und der Kühlkörper 4 anstelle der Laschen 13 einen die Befestigungsöffnungen 14 aufnehmenden Rand aufweist.

Jeder von den Befestigungsöffnungen 14 umgebene Befestigungsbolzen 15 besitzt einen gegenüber seinem Schaft verdickten Kopf 16. Den Schaft des Befestigungsbolzens 15 umgibt eine Spiralfeder 19, die einerseits an dem verdickten Kopf 16 und andererseits an der Lasche 13 des Kühlkörpers 4 anliegt. Infolgedessen wird der Kühlkörper 4 mit der Kraft der beiden Federn 19 gegen den Chip 2 gedrückt. Der Kraftschluß zur Platine 1 erfolgt über eine lösbare Rastverbindung 17 zwischen dem Befestigungsbolzen 15 und dem Sockel 7. Zu diesem Zweck wird die ebenfalls gegenüber dem Schaft des Befestigungsbolzens 15 verdickte Spitze durch eine im horizontalen Abschnitt des Sockels 7 eingebrachte, in der Figur nicht erkennbare Öffnung hindurchgesteckt. Nach dem Hindurchstecken der verdickten Spitze durch die Öffnung in dem Sockel 7 verhindern deren Schultern 18, daß der eingerastete Befestigungsbolzen 15 sich unbeabsichtigt aus dem Sockel 7 löst.

Die in Figur 2 gezeigte Anordnung unterscheidet sich von der nach Figur 1 darin, daß der Sockel 7 auf der Bestückungsseite 21 der Platine 1 verlötet ist. Im übrigen stimmt die elastische Verbindung zwischen Kühlkörper 4 und Platine 1 mit dem Ausführungsbeispiel nach Figur 1 überein, so daß zur Vermeidung von Wiederholungen auf die dortigen Ausführungen verwiesen wird.

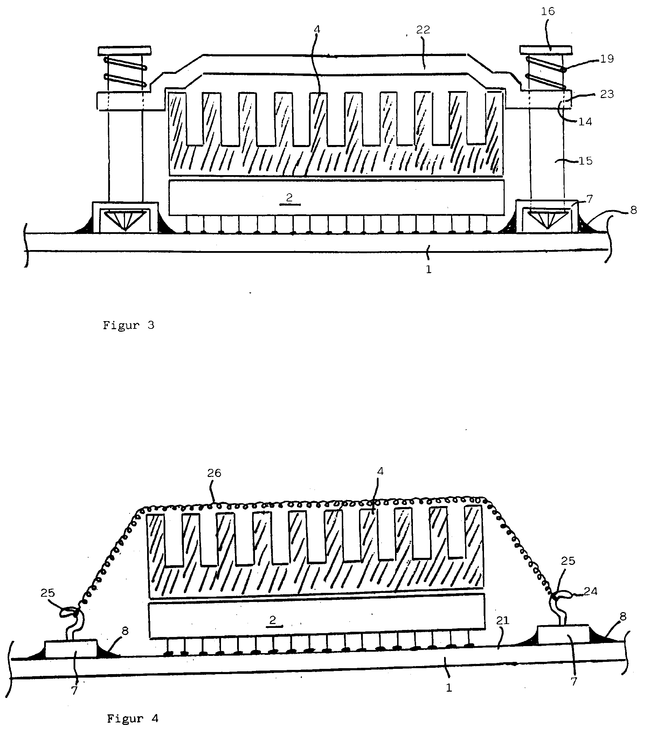

Das Ausführungsbeispiel nach Figur 3 entspricht hinsichtlich der Anordnung und Befestigung der Sockel 7 auf der Platine 1 dem Ausführungsbeispiel nach Figur 2. Abweichend zu den Ausführungsbeispielen nach den Figuren 1 und 2 wirkt der Befestigungsbolzen 15 jedoch nicht unmittelbar mit dem Kühlkörper 4 zusammen, sondern mit einem Haltebügel 22. Der Haltebügel 22 liegt formschlüssig auf dem Kühlkörper 4 auf, wobei sich seitliche Abschnitte 23 des Haltebügels 22 über die Oberfläche des Kühlkörpers 4 hinaus erstrecken. Die seitlichen Abschnitte 23 weisen übereinstimmend mit den in Figur 1 gezeigten Laschen 13 Befestigungsöffnungen 14 auf, durch die die Befestigungsbolzen 15 hindurchgeführt werden. Die den Schaft des Befestigungsbolzens umgebende Spiralfeder 19 liegt folglich nicht unmittelbar an dem Kühlkörper 4, sondern dem Halteelement 23 an, das die Kräfte der Spiralfedern 19 in den Kühlkörper 4 einleitet.

In dem Ausführungsbeispiel nach Figur 4 werden die Sockel 7 von Quadern aus Vollmaterial gebildet, die auf die Bestückungsseite 21 der Platine 1 gelötet sind. Die Sockel 7 nehmen jeweils einen Haken 24 auf, in den Ösen 25 einer über den Kühlkörper 4 gespannten Feder 26 eingreifen.

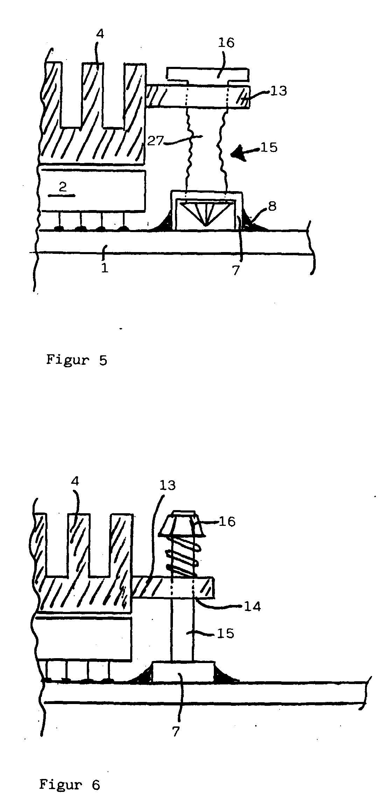

Die Ausführungsbeispiel nach Figur 5 unterscheidet sich von dem Ausführungsbeispiel nach Figur 2 darin, daß der Befestigungsbolzen 15 aus einem elastischen Schrumpfmaterial 27 besteht. Die Schrumpfung wird nach Ausrichtung des Kühlkörpers 4 auf dem Chip 2, Einstecken der ungeschrumpften Befestigungsbolzen 15 durch die Öffnungen 14 der Laschen 13 und Einrasten in den Öffnungen der Sockel 7 durch Zufuhr von Wärme in den Schaft des Bolzens herbeigeführt. Infolgedessen baut sich zwischen dem Kühlkörper 4 und der Platine 1 die für einen guten Wärmeübergang erforderliche Spannung auf. Der Kopf 16 des Befestigungsbolzens 15 liegt nach der Schrumpfung unmittelbar auf der Lasche 13 auf. Der elastische Schaft des Befestigungsbolzens 15 übernimmt die Funktion der Spiralfedern 19 in den Ausführungsbeispielen nach den Figuren 1, 2 und 3.

Der Kraftfluß zwischen Kühlkörper 4 und Platine 1 im Ausführungsbeispiel nach Figur 6 entspricht dem Kraftfluß der Ausführungsbeispiele nach den Figuren 1, 2 und 3. Der wesentliche Unterschied besteht darin, daß der Befestigungsbolzen 15 einstückig mit dem Sockel 7 ausgebildet ist. Der in dem Ausführungsbeispiel quaderförmige aus Vollmaterial bestehende Sockel 7 ist auf der Bestückungsseite 21 verlötet. Selbstverständlich kann der Sockel 7 auch mit Drahtstiften 9 entsprechend dem Ausführungsbeispiel nach Figur 1 versehen sein und auf der Rückseite der Platine 1 verlötet werden. Schließlich ist es nicht erforderlich, daß der Sockel 7 aus Vollmaterial besteht. Er könnte in gleicher Weise wie die Sockel in den Ausführungsbeispielen nach den Figuren 1, 2, 3 und 5 als Brücke ausgebildet sein.

Bei der einstückigen Ausbildung muß allerdings der Kopf 16 lösbar mit dem Schaft des Befestigungsbolzen 15 verbunden sein, um zunächst die Befestigungsöffnungen 14 in den Laschen 13 des Kühlkörpers 4 und anschließend die Spiralfedern 19 über den Schaft stülpen zu können. Der erforderliche Kraftschluß zwischen Kühlkörper 4 und Platine 1 wird schließlich durch den abnehmbaren, in Figur 6 als Clips ausgestalteten Kopf 16 hergestellt. Selbstverständlich läßt sich eine Anordnung nach dem Ausführungsbeispiel der Figur 6 auch in Verbindung mit einem Haltebügel 22 verwenden.

| **Bezugszeichenliste** | | | |
|---|---|---|---|
| 1. | Platine | 15. | Befestigungsbolzen |
| 2. | Chip | 16. | Kopf |
| 3. | Oberfläche (Chip) | 17. | Rastverbindung |
| 4. | Kühlkörper | 18. | Schalter |
| 5. | Unterseite (Kühlkörper) | 19. | Spiralfeder |
| 6. | Befestigungsmittel | 20. | --- |
| 7. | Sockel | 21. | Bestückungsseite |
| 8. | Lot | 22. | Haltebügel |
| 9. | Drahtstifte | 23. | Abschnitte |
| 10. | ---- | 24. | Haken |
| 11. | Löcher | 25. | Öse |
| 12. | Rückseite | 26. | Feder |
| 13. | Lasche | 27. | elastisches Schrumpfmaterial |
| 14. | Befestigungsöffnung | | |

## Patentansprüche

1. Anordnung mit einem auf einer Platine angeordneten elektronischen Bauteil, einem Kühlkörper sowie Befestigungsmitteln, wobei der Kühlkörper auf einer Oberfläche des elektronischen Bauteils aufliegt und die Befestigungsmittel den Kühlkörper elastisch mit der Platine verbinden, **dadurch gekennzeichnet,** daß die Befestigungsmittel (6) mindestens zwei Sockel (7) umfassen, die mit der Platine (1) durch Lot (8) verbunden sind.

2. Anordnung nach Anspruch 1, **dadurch gekennzeichnet,** daß das Lot (8) auf der Bestückungsseite (21) der Platine (1) aufgebracht ist.

3. Anordnung nach Anspruch 1, **dadurch gekennzeichnet,**
- daß jeder Sockel (7) mindestens einen Draht (9) aufweist,
- in der Platine (1) Löcher (11) vorgesehen sind, durch die die Drähte (9) der Sockel (7) gesteckt werden und
- das Lot (8) auf der Rückseite (12) der Platine (1) aufgebracht ist.

4. Anordnung nach einem der Ansprüche 1 bis 3, **dadurch gekennzeichnet,** daß der Kühlkörper (4) mindestens zwei Bereiche (13) aufweist, die sich über die Oberfläche des Bauteils (2) hinaus erstrecken und diese Bereiche (13) jeweils eine Befestigungsöffnung (14) zur Aufnahme eines Befestigungsbolzens (15) aufweisen, der einen gegenüber seinem Schaft verdickten Kopf (16) umfaßt und an der gegenüberliegenden Seite mit einem der Sockel (7) verbunden ist, wobei den Schaft des Bolzens (15) eine Spiralfeder (19) umgibt, die einerseits an dem verdickten Kopf (16) und andererseits an dem Kühlkörper (4) anliegt.

5. Anordnung nach einem der Ansprüche 1 bis 3, **dadurch gekennzeichnet,** daß auf dem Kühlkörper (4) ein Halteelement (22) aufliegt, das mindestens zwei Bereiche (23) aufweist, die sich über die Oberfläche des Kühlkörpers (4) und des darunter angeordneten Bauteils (2) hinaus erstrecken und diese Bereiche (23) jeweils eine Befestigungsöffnung (14) zur Aufnahme eines Befestigungsbolzens (15) aufweisen, der einen gegenüber seinem Schaft verdickten Kopf (16) umfaßt und an der gegenüberliegenden Seite mit einem der Sockel (7) verbunden ist, wobei den Schaft des Bolzens eine Spiralfeder (19) umgibt, die einerseits an dem verdickten Kopf (16) und andererseits an dem Halteelement (22) anliegt.

6. Anordnung nach einem der Ansprüche 1 bis 3, **dadurch gekennzeichnet**, daß der Kühlkörper (4) mindestens zwei Bereiche (13) aufweist, die sich über die Oberfläche des Bauteils (2) hinaus erstrecken und diese Bereiche (13) jeweils eine Befestigungsöffnung (14) zur Aufnahme eines Befestigungsbolzens (15) aufweisen, der einen elastischen aus Schrumpfmaterial (27) bestehenden Schaft mit verdickten Kopf (16) umfaßt und an der gegenüberliegenden Seite mit einem der Sockel (7) verbunden ist, wobei der verdickte Kopf (16) unmittelbar an dem Kühlkörper (4) anliegt.

7. Anordnung nach einem der Ansprüche 1 bis 3, **dadurch gekennzeichnet,** daß auf dem Kühlkörper (4) ein Halteelement (22) aufliegt, das mindestens zwei Bereiche (23) aufweist, die sich über die Oberfläche des Kühlkörpers (4) und des darunter angeordneten Bauteils (2) hinaus erstrecken und diese Bereiche jeweils eine Befestigungsöffnung (14) zur Aufnahme eines Befestigungsbolzens (15) aufweisen, der einen elastischen aus Schrumpfmaterial (27) bestehenden Schaft mit verdickten Kopf (16) umfaßt und an der gegenüberliegenden Seite mit einem der Sockel (7) verbunden ist, wobei der verdickte Kopf (16) unmittelbar an dem Halteelement (22) anliegt.

8. Anordnung nach einem der Ansprüche 4 bis 7, **dadurch gekennzeichnet,** daß zwischen dem Befestigungsbolzen (15) und dem Sockel (7) eine Rastverbindung (17) oder eine Renkverbindung, insbesondere eine Bajonettverbindung, oder ein Schraubverbindung besteht.

9. Anordnung nach einem der Ansprüche 4 bis 7, **dadurch gekennzeichnet,** daß der Befestigungsbolzen (15) einstückig mit dem Sockel (7) ausgebildet ist und der Kopf (16) des Bolzens von einem lösbar mit dem Schaft verbundenen und diesen umgebenden Ring gebildet wird.

10. Anordnung nach einem der Ansprüche 1 bis 3, **dadurch gekennzeichnet,** daß über den Kühlkörper (4) mindestens ein elastisches Zugmittel (26) gespannt ist, dessen Enden jeweils mit einem der Sockel (7) verbunden sind.

11. Anordnung nach Anspruch 10, **dadurch gekennzeichnet,** daß das Zugmittel (26) endseitig Ösen (25) aufweist, in die an den Sockeln (7) angeordnete Haken (24) eingreifen.
